# EUROPÄISCHE PATENTSCHRIFT

(11) **EP 2 912 204 B1**
(45) Veröffentlichungstag und Bekanntmachung des Hinweises auf die Patenterteilung: **14.03.2018**
(21) Anmeldenummer: 13789174.3
(22) Anmeldetag: 22.10.2013
(51) Int. Cl.: C23C 14/02, C23C 14/20, C23C 14/58, C23C 28/00

(54) **MIT EINER EINGEBETTETEN PVD-SCHICHT BESCHICHTETES KUNSTSTOFFTEIL**
PLASTIC COMPONENT COATED WITH AN EMBEDDED PVD LAYER
PIÈCE EN MATIÈRE PLASTIQUE REVÊTUE D'UNE COUCHE INTÉGRÉE FORMÉE PAR DÉPÔT PHYSIQUE EN PHASE VAPEUR

(30) Priorität: 23.10.2012 DE 102012020742
(43) Veröffentlichungstag der Anmeldung: 02.09.2015
(73) Patentinhaber: Oerlikon Surface Solutions AG, Pfäffikon, 8808 Pfäffikon (CH)
(72) Erfinder: RIBEIRO, Carlos, Ho Chi Minh City Vietnam (VN); BAUR, Sascha, 88605 Messkirch (DE)
(74) Vertreter: Troesch Scheidegger Werner AG
(86) Internationale Anmeldenummer: PCT/EP2013/003175
(87) Internationale Veröffentlichungsnummer: WO 2014/063808

(56) Entgegenhaltungen:
- WO-A2-2013/178363
- DE-A1-102010 019 913
- US-B1- 7 132 130

## Beschreibung

Die vorliegende Erfindung betrifft mit einer Beschichtung versehene Kunststoffteile. Sie betrifft insbesondere solche Teile, die für den Gebrauch im Freien vorgesehen und damit unterschiedlichen Witterungsbedingungen ausgesetzt sind. Hierzu gehören vor allem, aber nicht nur, solche Kunststoffteile welche im Aussenbereich an einem Fahrzeug angebracht sind. Für solche Kunststoffteile müssen auch nach längerer Anwendung optisch ansprechende Oberflächen erhalten bleiben.

Es ist bekannt, Kunststoffteile mittels Galvanikverfahren mit einer metallischen Schicht zu beschichten und damit eine metallisch aussehende Oberfläche zu realisieren. Solche galvanischen Verfahren stehen heute jedoch hinsichtlich Umweltverträglichkeit in der Kritik, denn die bei diesen Verfahren zu verwendenden Elektrolyten sind sehr giftig. Es müssen daher teure und aufwändige Techniken zum Einsatz kommen, um einerseits ein Entweichen dieser giftigen Substanzen zu verhindern und andererseits verbrauchte Elektrolyten umweltgerecht zu entsorgen.

Alternativ dazu bekannt ist das Beschichten von Kunststoffoberflächen mittels Vakuumbeschichtung, insbesondere mittels Abscheidung aus der Gasphase: Solche Verfahren führen zu einer PVD-Schicht, wobei PVD für physical vapor depostion steht.

In der EP1736566 wird ein Verfahren beschrieben, nach der für ein metallisches Finish eine Polymerschicht auf die Oberfläche eines thermoplastischen Substrates aufgebracht wird, wobei auf diese Polymerschicht mittels PVD eine metallische Schicht beispielsweise aus Chrom abgelagert wird. Die Aushärtung der Polymerschicht erfolgt beispielsweise über eine UV-Bestrahlung. In der EP1736566 wird nichts Explizites über das Anwendungsgebiet gesagt. Beim Fachmann stellt sich allerdings der Eindruck ein, es handle bei den in der EP1736566 erwähnten Artikeln um derartige Gebrauchsgegenstände wie zum Beispiel Behälter wie sie beispielsweise in der für Kosmetikindustrie zur Anwendung kommen. Umwelteinflüsse auf diese Artikel erscheinen eher zweitrangig. Die ist fern von der im Rahmen der vorliegenden Erfindung adressierten Thematik der Beschichtungen von Kunststoffteilen für den Fahrzeugbereich.

Im Zusammenhang mit der Beschichtung von Kunststoffteilen für den Fahrzeugbereich scheint ein Schichtaufbau besonders vielversprechend zu sein, demgemäss eine PVD Schicht zwischen einer auf das Kunststoffsubstrat aufgebrachten Lackgrundschicht und einer auf die PVD-Schicht aufgebrachten Decklackschicht angeordnet ist. Ein solches

### BESTÄTIGUNGSKOPIE

Schichtsystem ist in der DE19745407 offenbart. Dort wird ein Verfahren beschrieben, nach dem Kunststoffteile für Fahrzeuge beschichtet werden, welches folgende Schritte umfasst:
- Aufbringen einer Lackschicht aus einem Pulvereinbrennlack
- Aufstäuben einer Hochglanzschicht aus einer Metalllegierung oder einer Metallverbindung mittels eines Magnetrons im Vakuum
- Aufbringen einer transparenten, verschleissfesten Decklackschicht

Dabei ist klar, dass die Decklackschicht den Umwelteinflüssen am ehesten ausgesetzt ist. In der DE19745407 wird daher vorgeschlagen diese Decklackschicht mittels einer CVD Methode aufzubringen. Hinsichtlich der Grundlackschicht muss demgegenüber im Wesentlichen darauf geachtet werden, dass die Grundlackschicht auf dem Substrat gut haftet und dass die PVD-Schicht auf der Grundlackschicht gut haftet. Die gute Haftung der Grundlackschicht auf dem Substrat wird in der DE19745407 dadurch erreicht, dass als Grundlackschicht ein Pulvereinbrennlack verwendet wird. Dies erscheint in der DE19745407 zwingend. Die gute Haftung der PVD-Schicht auf der Grundlackschicht wird in der DE19745407 dadurch erreicht, dass vor dem Aufstäuben der Hochglanzschicht eine Vorbehandlung im Vakuum durchgeführt wird, insbesondere durch Aufbringung einer Haftvermittlerschicht. Was als Haftvermittlerschicht dienen könnte und wie diese unter Vakuum aufgebracht wird, wird allerdings nicht beschrieben.

Ein weiteres Schichtsystem ist in der US7132130B1 offenbart. Der vorliegenden Erfindung liegt die Aufgabe zugrunde, ein beschichtetes Kunststoffteil für Fahrzeuge anzugeben, dessen Beschichtung dem Kunststoffteil eine gewünschtes Aussehen verleiht, wobei die Oberfläche eine hohe Wetterbeständigkeit aufweist und gegen starke Umwelteinflüsse wie zum Beispiel Steinschlag zumindest in gewissem Umfang geschützt ist und wobei die Beschichtung wirtschaftlich, kostengünstig und umweltfreundlich vorgenommen werden kann.

Erfindungsgemäss lässt sich die Aufgabe mit einem beschichteten Kunststoffteil gemäss Anspruch 1 lösen. Die Erfinder haben nämlich festgestellt, dass sich ein gegenüber Umwelteinflüssen stabil beschichtetes Kunststoffteil dadurch realisieren lässt, dass eine zumindest dreilagige PVD Schicht zum Einsatz kommt, welche auf eine Grundlackschicht aufgebracht wird. Vorzugsweise wird auf die zumindest dreilagige PVD Schicht eine Decklackschicht aufgebracht. Kern dieser zumindest dreilagigen PVD Schicht ist eine im Mittelbereich liegende dicke Pufferschicht welche dem Gesamtschichtsystem Stabilität verleiht. Zwischen Pufferschicht und Grundlackschicht ist erfindungsgemäss eine Haftschicht vorgesehen. Auf der Pufferschicht ist erfindungsgemäss eine farbgebende Schicht vorgesehen. Es hat sich gezeigt, dass aufgrund dieses erfindungsgemässen Aufbaus auf den teuren Pulvereinbrennlack und das entsprechende Verfahren verzichtet werden kann. Vermutlich führt die Pufferschicht zu mechanischen Eigenschaften des PVD-Schichtsystems welche ein Ablösen des Grundlackes von der Substratoberfläche erschweren. Als Materialien des PVD-Schichtsystems kommen vor allem die Elemente der Gruppen IVb, Vb und Vlb des Periodensystems der Elemente und Aluminium sowie Mischungen daraus und/oder deren entsprechenden Nitride, Oxide und/oder Carbide in Frage. Dotierungen mit Elementen der Gruppen IIIA und/oder IVA des Periodensystems der Elemente können vorteilhaft sein.

Als Grundlack lässt sich daher beispielsweise ein photosensitiver Lack einsetzen, welcher mittels UV-Bestrahlung vernetzt werden kann und der mit einem einfachen Aufspritzverfahren aufgebracht werden kann.

Vorzugsweise wird auf der farbgebenden PVD-Schicht eine Decklackschicht vorgesehen, welche die darunterliegende PVD-Schicht sowohl chemisch, beispielsweise gegen Korrosion als auch mechanisch, beispielsweise gegen Steinschlag schützt.

Als Decklack eignet sich beispielsweise ein transparenter photosensitiver Lack, welcher mittels UV-Bestrahlung vernetzt werden kann und der mit einem einfachen Aufspritzverfahren aufgebracht werden kann. Gemäss einer besonders bevorzugten Ausführungsform umfasst der UV-vernetzende Lack zusätzlich UV-blockierende Substanzen. Durch die UV-blockierenden Substanzen erhöht sich zwar die Zeit, mit der der Decklack zur seiner vollständigen Vernetzung beaufschlagt werden muss. Kunststoffteile welche im Aussenbereich eines Fahrzeuges angebracht sind, sind jedoch häufig intensiver Sonnenbestrahlung ausgesetzt. Die Einbringung von UV-blockierenden Substanzen in den UV-vernetzenden Decklack führt aufgrund der blockierenden Wirkung zu einer langsameren Alterung (z.B. Vergilbung) und damit zu einem länger anhaltenden optisch ansprechenden Aussehen des Kunststoffteils.

Die Erfindung wird nun anhand von Beispielen und mit Hilfe der Figur im Detail erläutert.

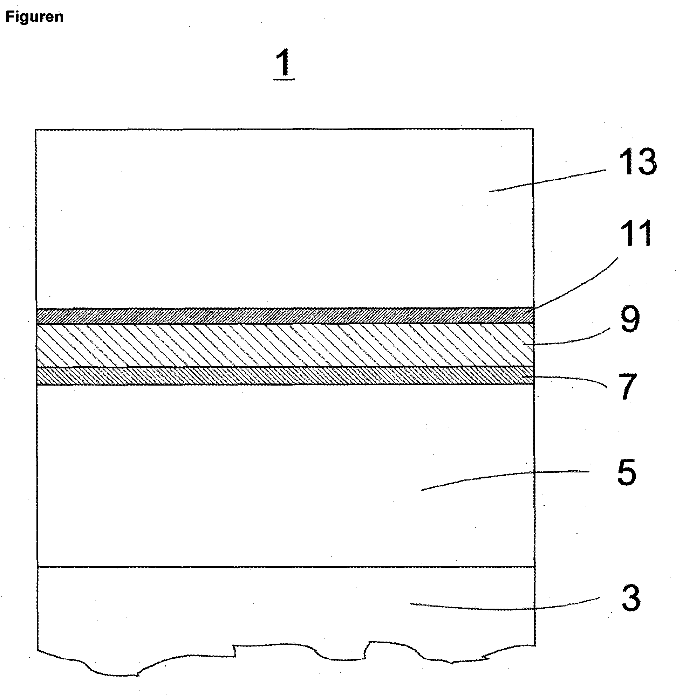

Figur 1 zeigt schematisch den Schichtaufbau gemäss einer Ausführungsform der vorliegenden Erfindung.

Gemäss einer ersten Ausführungsform der vorliegenden Erfindung wird eine 10µm dicke Grundlackschicht auf ein Kunststoffsubstrat aufgebracht. Hierzu wird das Substrat zunächst gereinigt, getrocknet und entladen, bevor der UV-vernetzende Lack mittels einer Lackiervorrichtung aufgespritzt wird. Die derart behandelten Substrate werden im Beispiel mittels IR-Bestrahlung von etwaigen Lösungsmitteln befreit und getrocknet. Anschliessend erfolgt eine intensive UV-Bestrahlung um die Grundlackschicht zu vernetzen.

Nachdem die Grundlackschicht aufgebracht, getrocknet und vernetzt ist, wird das Substrat in eine PVD Beschichtungsanlage eingeschleust. Bei der Beschichtungsanlage handelt es sich im vorliegenden Beispiel um eine Magnetron-Sputteranlage. Das zu beschichtende Material wird von einem sogenannten Sputtertarget mittels Ionenbeschuss zerstäubt und schlägt sich auf dem zu beschichtenden Substrat nieder. Im vorliegenden Beispiel kommt eine Inlineanlage zum Einsatz, in der das Substrat zunächst an Chromtargets vorbeigeführt wird. Hierdurch wird eine 30nm dicke Chromschicht auf den Grundlack aufgestäubt. Anschliessend wird das Substrat in der PVD-Beschichtungsanlage an Zirkon-Targets vorbeigeführt und es wird eine 100nm dicke Pufferschicht aus Zirkon aufgestäubt. Abschliessend wird das Substrat nochmals an Chrom-Targets vorbeigeführt, was zum Aufstäuben einer 60nm dicken Farbschicht aus Chrom führt. Nachdem das gewünschte erfindungsgemässe PVD-Schichtsystem auf dem Substrat aufgebracht wurde, wird das Substrat aus der PVD-Beschichtungsanlage ausgeschleust.

Wesentlich für die Stabilität des Gesamtschichtsystems ist die Pufferschicht, die im vorliegenden Beispiel durch die Zirkonschicht gebildet wird. Wie die Erfinder herausgefunden haben, ist es weiterhin vorteilhaft dieser Pufferschicht eine innere Struktur aufzuprägen. Gemäss der vorliegenden Erfindung wird die Pufferschicht aus mehreren unterschiedlichen Schichtmaterialien unterschiedlicher Härte und/oder Elastizität aufgebaut. Im vorliegenden Beispiel wurde allerdings lediglich Zirkon als Schichtmaterial für die Pufferschicht verwendet. Um der Pufferschicht eine innere Struktur aufzuprägen wurden während des Beschichtens die Prozessparameter moduliert. Einerseits wurde die Beschichtung in 6 Beschichtungsintervalle unterteilt welche durch Beschichtungspausen getrennt waren, wobei eine sich an ein Beschichtungsintervall anschliessende Beschichtungspause in etwa die halb so lang wie das Beschichtungsintervall gewählt wurde. Andererseits wurde die Stromstärke variiert. So wurde die Stromstärke für die letzten drei Beschichtungsintervalle gegenüber der Stromstärke für die ersten drei Beschichtungintervalle um ca. 20% reduziert. Im vorliegenden Beispiel wurden für die ersten drei Beschichtungsintervalle 28 Ampere verwendet während für die letzten drei Beschichtungsintervalle 24 Ampere verwendet wurden. Durch dieses Vorgehen wird in der Pufferschicht vermutlich eine tiefenabhängige Dichteverteilung eingeführt, so dass sich dichte mit weniger dichten Bereichen abwechseln und so die Pufferschicht stabilisieren. Vorzugsweise sind die dadurch entstehenden Schichtlagen im SEM aufzulösen.

Gemäss einer bevorzugten Ausführungsform der vorliegenden Erfindung wird nun noch eine 20µm dicke Decklackschicht aus UV-vernetzendem Lack, der besonders bevorzugt mit einer oder mehreren UV-blockierenden Substanzen versehen ist, beschichtet. Dabei kann entsprechend dem für die Grundlackschicht beschriebenen Verfahren zu Anwendung kommen. Allerdings muss die PVD-beschichtete Oberfläche nicht gereinigt werden, sofern das PVD-beschichtete Kunststoffteil im Wesentlichen direkt anschliessend an die PVD-Beschichtung mit Lack beschichtet wird.

Von ganz besonderem Vorteil dieser Ausführungsform ist, dass die PVD-Schicht keine Aluminuimoberfläche zur Decklackschicht bildet.

Gemäss einer zweiten Ausführungsform der vorliegenden Erfindung wird ebenfalls eine 10µm dicke Grundlackschicht auf ein Kunststoffsubstrat aufgebracht. Hierzu wird das Substrat zunächst gereinigt, getrocknet und entladen, bevor der UV-vernetzende Lack mittels einer Lackiervorrichtung aufgespritzt wird. Die derart behandelten Substrate werden im Beispiel mittels IR-Bestrahlung von etwaigen Lösungsmitteln befreit und getrocknet. Anschliessend erfolgt eine intensive UV-Bestrahlung um die Grundlackschicht zu vernetzen.

Nachdem die Grundlackschicht aufgebracht, getrocknet und vernetzt ist, wird das Substrat in eine PVD Beschichtungsanlage eingeschleust. Bei der Beschichtungsanlage handelt es sich im vorliegenden Beispiel um eine Magnetron-Sputteranlage. Das zu beschichtende Material wird von einem sogenannten Sputtertarget mittels Ionenbeschuss zerstäubt und schlägt sich auf dem zu beschichtenden Substrat nieder. Im vorliegenden Beispiel kommt eine Inlineanlage zum Einsatz, in der das Substrat zunächst an Chromtargets vorbeigeführt wird. Hierdurch wird eine 60nm dicke Chromschicht auf den Grundlack aufgestäubt. Bevorzugt sind Schichtdicken von 20nm bis 100nm.

Anschliessend wird das Substrat in der PVD-Beschichtungsanlage an Aluminium -Targets vorbeigeführt und es wird eine 200nm dicke Pufferschicht aus Aluminium aufgestäubt. Bevorzugt sind Schichtdicken von 80nm bis 250nm.

Die abschliessende Farbschicht wird schliesslich zweiteilig aufgebaut. Zunächst wird, wiederum mittels zerstäuben eine 60nm dicke Chromschicht aufgestäubt. Dies sorgt für einen Blaustich der Oberfläche. Bevorzugt sind Schichtdicken von 20nm bis 100nm. Abschliessend wird das Substrat nochmals an Aluminium - Targets vorbeigeführt, was zum Aufstäuben einer 35nm dicken Schicht aus Aluminium führt und die Farbe aufhellt. Bevorzugt sind Schichtdicken von 10nm bis 50nm.

Auch bei dieser zweiten Ausführungsform kann es von Vorteil sein, eine Decklackschicht vorzusehen. Gemäss dieser bevorzugten Ausführungsform der vorliegenden Erfindung wird nun noch eine 20µm dicke Decklackschicht aus UV-vernetzendem Lack, der besonders bevorzugt mit einer oder mehreren UV-blockierenden Substanzen versehen ist, beschichtet. Dabei kann entsprechend dem für die Grundlackschicht beschriebenen Verfahren zu Anwendung kommen. Allerdings muss die PVD-beschichtete Oberfläche nicht gereinigt werden, sofern das PVD-beschichtete Kunststoffteil im Wesentlichen direkt anschliessend an die PVD-Beschichtung mit Lack beschichtet wird. Da die äusserste PVD-Schicht jedoch eine Aluminiumschicht ist und Aluminium sehr leicht eine Verbindung mit Sauerstoff eingeht kann es zur Bildung einer Aluminiumoxidschicht kommen, welche Einfluss auf die Haftung der Decklackschicht auf der PVD-Schicht haben kann. Demzufolge hat die oben beschriebene erste Ausführungsform der vorliegenden Erfindung den Vorteil, dass hierbei auf Aluminium gänzlich verzichtet werden kann.

Das damit entstandene Kunststoffteil kann beispielsweise bei Kraftfahrzeugen im Innenbereich und/oder im Aussenbereich angeordnet werden. Als Beispiele für den Aussenbereich seien die Zierleiste und der Kühlergrill genannt.

## Patentansprüche

1. Kunststoffteil umfassend ein Substrat und ein auf das Substrat aufgebrachtes Schichtsystem wobei direkt auf dem Substrat eine erste Lackschicht aufgebracht ist und auf die Lackschicht ein PVD Schichtsystem folgt, **dadurch gekennzeichnet, dass** das PVD Schichtsystem zumindest eine erste Schicht, eine zweite Schicht und eine dritte Schicht umfasst, wobei die erste Schicht auf der ersten Lackschicht liegt und als Haftschicht ausgeführt ist, die zweite Schicht als stabilisierende Pufferschicht ausgebildet ist und die dritte Schicht als farbgebende Schicht ausgeführt ist, wobei die Pufferschicht eine im SEM als Schichtlagen sichtbare innere Struktur aufweist und/oder Schichtlagen der Pufferschicht unterschiedliche Eigenschaften hinsichtlich Härte und/oder Elastizität aufweisen.

2. Kunststoffteil nach Anspruch 1, **dadurch gekennzeichnet, dass** die Pufferschicht Zirkon umfasst.

3. Kunststoffteil nach Anspruch 2, **dadurch gekennzeichnet, dass** die Pufferschicht eine Zirkonschicht ist.

4. Kunststoffteil nach einem der vorhergehenden Ansprüche, **dadurch gekennzeichnet, dass** die Grundlackschicht eine Dicke zwischen 5 µm und 40 µm aufweist und vorzugsweise 10 µm dick ist.

5. Kunststoffteil nach einem der vorangehenden Ansprüche, **dadurch gekennzeichnet, dass** die erste Lackschicht eine UV-vernetzte Schicht aus photosensitivem Lack ist.

6. Kunststoffteil nach einem der vorangehenden Ansprüche, **dadurch gekennzeichnet, dass** auf der PVD-Schicht eine Decklackschicht vorgesehen ist.

7. Kunststoffteil nach Anspruch 6, **dadurch gekennzeichnet, dass** die Decklackschicht eine UV-vernetzte Schicht aus photosensitivem Lack ist.

8. Kunststoffteil nach einem der Ansprüche 6 oder 7, **dadurch gekennzeichnet, dass** die Decklackschicht UV Blocker umfasst.

9. Kunststoffteil nach einem der vorangehenden Ansprüche, **dadurch gekennzeichnet, dass** die Schichtlagen sich durch unterschiedliche Materialkonzentrationen und/oder durch eine tiefenabhängige Dichtefunktion auszeichnen.

10. Kunststoffteil nach einem der vorangehenden Ansprüche, **dadurch gekennzeichnet, dass** die Haftschicht Chrom umfasst und vorzugsweise eine Chromschicht ist.

11. Kunststoffteil nach einem der vorangehenden Ansprüche, **dadurch gekennzeichnet, dass** die Farbschicht Chrom und/oder Aluminium umfasst, wobei die Farbschicht vorzugsweise aus einer Chromschicht und einer darüber liegenden Aluminiumschicht aufgebaut ist.

12. Kraftfahrzeug mit im Innenbereich und/oder Aussenbereich angeordnetem Kunststoffteil nach einem der vorangehenden Ansprüche.

## Claims

1. Plastic part, comprising a substrate and a layer system applied to the substrate, wherein a first lacquer layer is applied directly to the substrate and a PVD layer system follows the lacquer layer, **characterized in that** the PVD layer system comprises at least a first layer, a second layer and a third layer, wherein the first layer lies on the first lacquer layer and is designed as an adhesive layer, the second layer is formed as a stabilizing buffer layer and the third layer is designed as a coloring layer, wherein the buffer layer has an internal structure visible in the SEM as layers and/or the layers of the buffer layer have different properties in terms of hardness and/or elasticity.

2. Plastic part according to claim 1, **characterized in that** the buffer layer comprises zirconium.

3. Plastic part according to claim 2, **characterized in that** the buffer layer is a zirconium layer.

4. Plastic part according to one of the preceding claims, **characterized in that** the base lacquer layer has a thickness of between 5 µm and 40 µm and is preferably 10 µm thick.

5. Plastic part according to one of the preceding claims, **characterized in that** the first lacquer layer is a UV-crosslinked layer of photosensitive lacquer.

6. Plastic part according to one of the preceding claims, **characterized in that** a cover lacquer layer is provided on the PVD layer.

7. Plastic part according to claim 6, **characterized in that** the cover lacquer layer is a UV-crosslinked layer of photosensitive lacquer.

8. Plastic part according to one of the claims 6 or 7, **characterized in that** the cover lacquer layer comprises UV blockers.

9. Plastic part according to one of the preceding claims, **characterized in that** the layers are **characterized by** different material concentrations and/or by a depth-dependent density function.

10. Plastic part according to one of the preceding claims, **characterized in that**
the adhesive layer comprises chromium and is preferably a chromium layer.

11. Plastic part according to one of the preceding claims, **characterized in that**
the color layer comprises chromium and/or aluminum, wherein the color layer is preferably constructed from a chromium layer and an overlying aluminum layer.

12. Motor vehicle, comprising a plastic part according to one of the preceding
claims which is arranged in the interior area and/or in the outside area.

## Revendications

1. Pièce en matière plastique comprenant un substrat et un système stratifié déposé sur le substrat, une première couche de laque étant déposée directement sur le substrat et un système stratifié déposé par PVD étant ensuite déposé sur la couche de laque, **caractérisée en ce que** le système stratifié déposé par PVD comprend au moins une première couche, une deuxième couche et une troisième couche, la première couche se trouvant sur la première couche de laque et étant réalisée comme une couche d'adhérence, la deuxième couche étant réalisée comme une couche tampon stabilisatrice et la troisième couche étant réalisée comme une couche colorante, dans laquelle la couche tampon présente une structure interne visible dans le SEM comme feuille de stratifié et/ou dans laquelle les feuilles de stratifié de la couche tampon présentent différentes propriétés en ce qui concerne la dureté et/ou l'élasticité.

2. Pièce en matière plastique selon la revendication 1, **caractérisée en ce que** la couche tampon comprend du zirconium.

3. Pièce en matière plastique selon la revendication 2, **caractérisée en ce que** la couche tampon est une couche de zirconium.

4. Pièce en matière plastique selon l'une des revendications précédentes, **caractérisée en ce que** la couche de laque de base présente une épaisseur comprise entre 5 µm et 40 µm, de préférence une épaisseur de 10 µm.

5. Pièce en matière plastique selon l'une des revendications précédentes, **caractérisée en ce que** la première couche de laque est une couche réticulée par UV de laque photosensible.

6. Pièce en matière plastique selon l'une des revendications précédentes, **caractérisée en ce qu'**il est prévu sur la couche PVD une couche de finition.

7. Pièce en matière plastique selon la revendication 6, **caractérisée en ce que** la couche de finition est une couche réticulée par UV de laque photosensible.

8. Pièce en matière plastique selon l'une des revendications 6 ou 7, **caractérisée en ce que** la couche de finition comprend des bloqueurs d'UV.

9. Pièce en matière plastique selon l'une des revendications précédentes, **caractérisée en ce que** les feuilles de stratifié se caractérisent par des concentrations de matériau différentes et/ou par une fonction d'étanchéité suivant la profondeur.

10. Pièce en matière plastique selon l'une des revendications précédentes, **caractérisée en ce que** la couche d'adhérence comprend du chrome et est de préférence une couche de chrome.

11. Pièce en matière plastique selon l'une des revendications précédentes, **caractérisée en ce que** la couche de couleur comprend du chrome et/ou de l'aluminium, la couche de couleur étant constituée de préférence d'une couche de chrome avec au-dessus une couche d'aluminium.

12. Véhicule comprenant à l'intérieur et/ou à l'extérieur une pièce en matière plastique selon l'une des revendications précédentes.
